Europäisches Patentamt

European Patent Office

Office européen des brevets

(19)

(11) EP 0 886 373 A1

(12) **EUROPEAN PATENT APPLICATION**

(43) Date of publication:
    23.12.1998 Bulletin 1998/52

(51) Int Cl.⁶: **H03G 3/30**, H04B 1/707,
    H04B 7/08

(21) Application number: 98304791.1

(22) Date of filing: 17.06.1998

(84) Designated Contracting States:
    **AT BE CH CY DE DK ES FI FR GB GR IE IT LI LU
    MC NL PT SE**
    Designated Extension States:
    **AL LT LV MK RO SI**

(30) Priority: **20.06.1997 GB 9713145**

(71) Applicant: **NOKIA MOBILE PHONES LTD.
    02150 Espoo (FI)**

(72) Inventor: **Helakorpi, Ilkka
    90550 Oulu (FI)**

(74) Representative: **Jeffery, Kendra Louise et al
    Nokia Mobile Phones,
    Patent Department,
    St. Georges Court,
    St. Georges Road
    Camberley, Surrey GU15 3QZ (GB)**

(54) **Gain control for a CDMA receiver**

(57)    A gain control circuit 19 for a CDMA receiver including a controllable input amplifier 12, comprising a first input port for receiving a wideband power level signal from a wideband stage of said receiver; a second input port for receiving a narrowband power level signal from a narrowband stage of said receiver; and a combiner for combining said wideband and narrowband signals to generate a gain control signal for supply to said input amplifier.

Fig.2.

EP 0 886 373 A1

## Description

This invention relates to gain control in a CDMA receiver.

Automatic gain control is frequently provided in radio receivers. It is important in CDMA radio receivers (such as those employed and proposed for use in cellular and personal communications networks), because the range of the transmitted downlink signal (i.e. the signal transmitted to the mobile terminals) in such networks depends upon the number of active CDMA code channels, increasing with increasing numbers of channels. The dynamic range of the downlink signals can be 80 dB.

For practical receivers, the dynamic range is constrained by the hardware. If the received signal is too strong, analog components of the receiver can saturate. Furthermore, digital components of the receiver have typically fixed word lengths, so a signal which is too weak before digitisation will attract substantial quantiser error on digitisation. It is therefore highly desirable to maintain the dynamic range of the signal aligned with the working ranges of the analog and digital components of the receiver using an automatic gain control.

The receiver initially accepts the multiplexed downlink signal, which includes a large number of CDMA channels and is a wideband signal by virtue of the spectrum-spreading effect of CDMA. The particular CDMA channel of interest to the receiver is extracted, by convolving (in the frequency domain) or multiplying (in the time domain) the received signal with a locally generated code. corresponding to that with which the information for the receiver was modulated at the transmitter. After this process. the received signal is no longer a spread spectrum signal but a baseband (i.e narrowband) signal carrying. for example, audio data. This demultiplexing or extracting of the desired CDMA channel is therefore sometimes referred to as "despreading"

Several AGC arrangements are known in the prior art. For example, US 5099204 and US 5107225 disclose arrangements in which automatic gain control is performed by setting the gain of the receiver in accordance with the magnitude of the received wideband signal, and US 4993044, US 5168505 and US 5132985 show AGC arrangement in which the receiver gain is set in accordance with the long term magnitude of the narrowband (i.e. despread or baseband) signal.

The present inventor has realised that neither of these arrangements is ideal. If the narrowband signal after despreading is employed, the gain will be correctly matched for the digital components which operate on the despread signal, but the earlier analog stages may still saturate since adding more users will increase the range of the wideband downlink signal without necessarily affecting the range of the despread signal. The converse is also true.

Accordingly, in the present invention, we provide an AGC circuit for a CDMA receiver in which the gain is controlled in response to a combination of the wideband and narrowband received power levels.

Other aspects and preferred embodiments of the invention will be apparent from the following description and drawings in which:

Figure 1 is a block diagram showing the elements of a CDMA communications network embodying the invention;

Figure 2 is a block diagram of a CDMA communications receiver according to an embodiment of the invention;

Figure 3 is a block diagram showing the structure of a gain controller forming part of the embodiment of Figure 2;

Figure 4 is a block diagram showing the structure of a demultiplexer forming part of the receiver of Figure 2 according to a preferred embodiment of the invention; and

Figure 5 is a block diagram showing in greater detail one branch of the receiver of Figure 4.

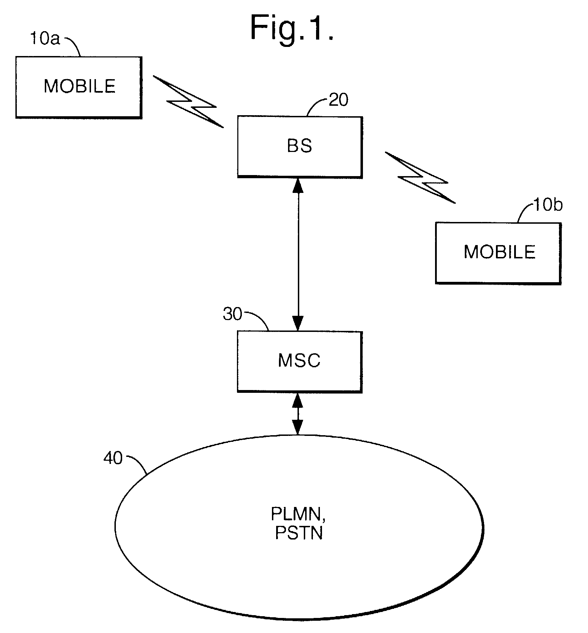

Referring to Figure 1, a telecommunication system within which the present invention is embodied comprises mobile terminal units 10a, 10b (for example, cellular telephones or personal communicators such as the Nokia 9000) in RF communications with one or more base stations 20, which are interconnected via one or more mobile switching centres 30 to the communications network 40 comprising the public switched telecommunications network, one or more public land mobile networks, or the like. For example, the telecommunications system depicted in Figure 1 may be a CDMA cellular telecommunications network.

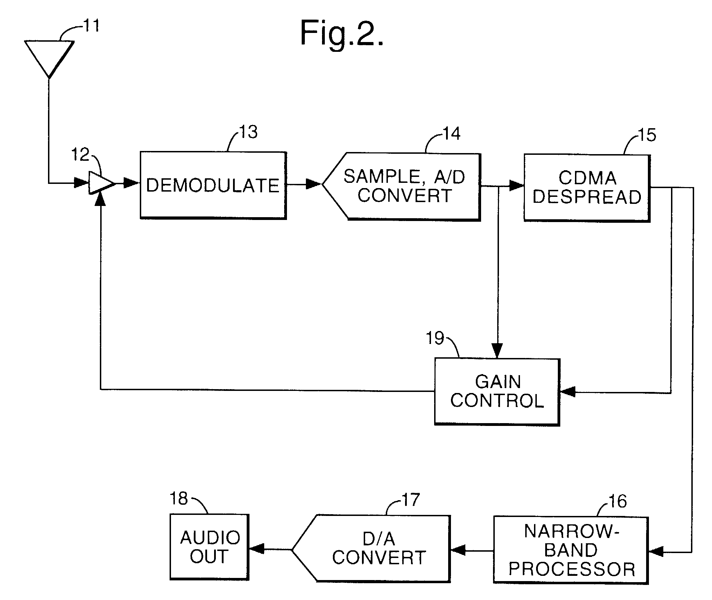

Referring to Figure 2. the structure of the receiver will now be disclosed in greater detail. The downlink signal from the base station 20 is received by the receiver antenna 11. and amplified by a controllable gain amplifier 12. Other conventional RF reception processors such as band filter may also take place.

The amplified signal is demodulated (for example to intermediate frequency, or IF) by a demodulator 13, then sampled and digitised by an ADC 14 and CDMA demodulated or despread by a demultiplexer 15. The despreadd signal is then processed to perform error correcting decoding and source decoding, for example, by a narrowband processing stage 16; then converted to an analog output by a DAC 17 and regenerated at a loudspeaker 18. Naturally, where the transmitted information is other than a voice signal, the data is supplied to an alternative output stage such as a data port.

The gain of the amplifier 12 is controlled by a gain control circuit 19, which receives (at least) two inputs: a first input from a point at which the signal is still a wideband CDMA signal (for example, as shown here, after the ADC 14) and a second input from at a stage at which the signal is a narrowband signal (for example. as shown, at the output of the CDMA despreading stage 15). On the basis of these inputs, the gain control circuit 19 generates a control signal which is supplied to the amplifier 12 to control the gain thereof.

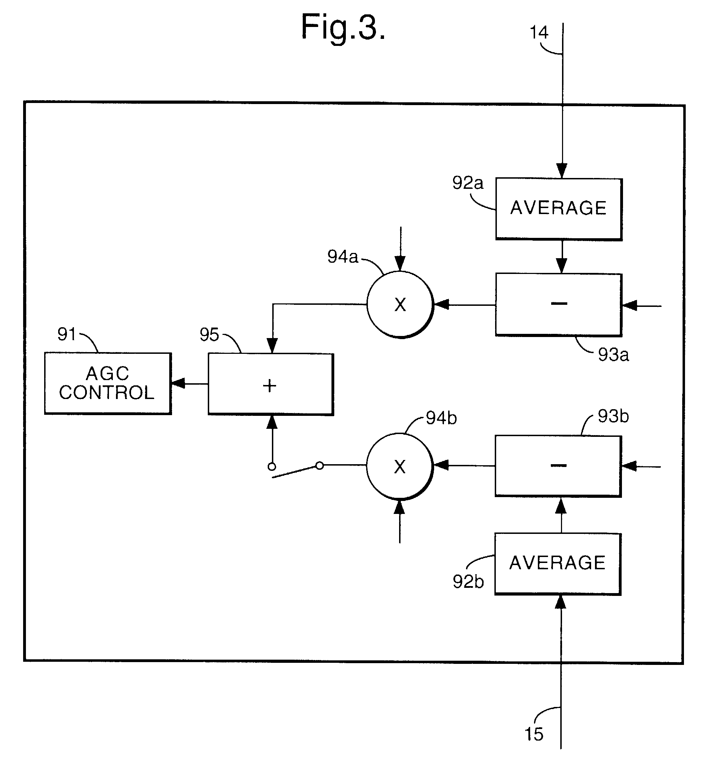

Referring to Figure 3. the structure of the gain control circuit 19 will now be described in greater detail. A conventional AGC control circuit 91, matched to the amplifier 12, receives the output of an adder 95 which generates the sum of the magnitudes of the signals in two paths; one from the output of the sample and conversion circuit 14 and the other from the CDMA despreading circuit 15. In each of the paths is provided a long term averager 92a, 92b; a subtractor 93a, 93b subtracting the averaged signal from a reference value; and a multiplier 94a, 94b scaling the resulting error signal by a predetermined weighting system.

In greater detail, in each branch the averager 92a, 92b integrates or averages the signal power over a (relatively long) period of 0.1-10 milliseconds. The averaging time may, in this embodiment, be controllably varied in dependence upon the measured coherence time of the channel. The averaged signal is subtracted at the subtractor 93a. 93b from a reference signal which, in this embodiment, lies at the centre of the dynamic range of the relevant stage for the signal; in other words, the reference level $r_b$ for the wideband signal component corresponds to half the dynamic range of the RF wideband circuitry, and the predetermined reference level $r_n$ for the narrowband signal corresponds to half the range of the digital processing circuitry that follows.

The difference between the average signal level and this reference signal therefore indicates, for each of the wideband and the narrowband signals, the extent and direction by which the average level of the incoming signal is mismatched to the range of the wideband or narrowband stages of the receiver.

At the weighting multipliers 94a, 94b, each error signal thus calculated is multiplied by a predetermined weight, $w_b$, $w_n$.

The weights are selected for example, such that each lies between zero and 1, and the sum of the weights is one. in other words:

$$0 = w_b, \ w_n = 1 \qquad (1)$$

$$w_b + w_n = 1 \qquad (2)$$

For example, in this embodiment, $w_b$ may be 0.7 and $w_n$ may be 0.3, so that the error signal depends predominantly on the value of the wideband signal but takes into account the narrowband signal to a lesser extent.

The controller 19 may be a post integration detection (PID) controller of a type well known in control circuits and is selected, together with the amplifier 12, in dependence upon the powers and intended application of the receiver.

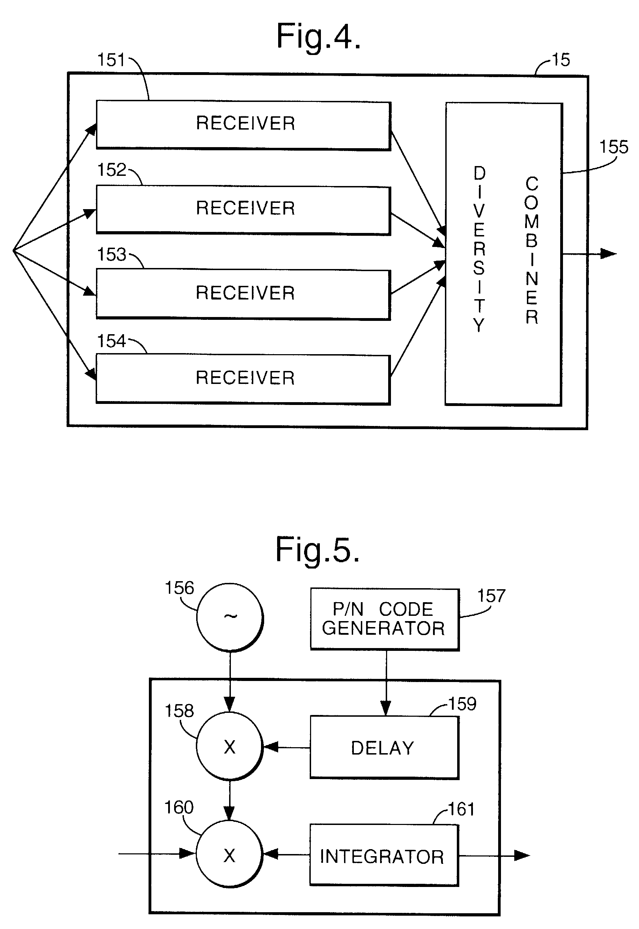

Referring to Figure 4, in this embodiment the CDMA despreader 15 comprises a plurality of alternative despreader branches 151-154 each arranged to despread the received CDMA signal with a different time delay. Where multipath distortion of the signal is present, two or more of the branches 151-154 may acquire differently delayed signal components which have undergone different paths to the receiver. A diversity combiner 155 is provided, which may operate using either switched diversity (i.e. by selecting the strongest output signal of those of the four branches - 151-154) or shared diversity (i.e. by forming a combination of the outputs of the four branches 151-154).

Referring to Figure 5, each of the branches 151-154 comprises a multiplier 158 connected to receive the output of a (common) chip-rate clock and multiply it by the pseudo noise (P/N) code output by a (common) code generator 157, fed through a respective delay 159 specific to each of the branches 151-154. The delayed signal is then fed to a multiplier 160 at which it is multiplied with the incoming received signal, and the result is feed to an integrator 161 at which it is integrated over one data symbol period (i.e over the entire length of the chip or P/N code sequence).

The structure thus described corresponds to a multiple-branch RAKE receiver as is well known in the art. A preferred embodiment incorporated herein by reference, is described in European Patent Application EP 0691754, "Dynamic control of acquisition and tracking of the correlators in a RAKE receiver".

If the receiver is within range of a base station, one or more of the branches will detect a signal at an acceptable bit error rate. The branch receiving the strongest signal is detected and used for reception.

In the present embodiment, the signal from this branch is used to supply the narrowband level signal.

In the early stages of operation of the receiver, for example after restoring power or after reacquiring a base station carrier (after emerging from a tunnel or a building), little valuable information is obtained from the signals from the branches of the receiver. Accordingly, in this embodiment, the gain control circuit comprises a switch 96 arranged to switch out the narrowband branch until a predetermined bit error rate (BER) is obtained.

It will be apparent that many other embodiments of the invention are possible. For example, rather than providing a switch 96, the gain controller may comprise a control device arranged to apply a gradually increasing level to the narrowband weight $w_n$. The narrowband signal may, rather than being based on the strongest branch, be based on a weighted sum of all the branches.

Rather than using a linear combination of the two power levels as described above, some non-linear function (in which, for example, one or both is raised to a higher power) may be used. This may be advantageous where, for example, the A/D convertor, or the amplifier, is non-linear itself.

Many other modifications variations and alternatives will be apparent to the skilled person. all of which will be understood to be within the scope of the present invention.

The scope of the present disclosure includes any novel feature or combination of features disclosed therein either explicitly or implicitly or any generalisation thereof irrespective of whether or not it relates to the claimed invention or mitigates any or all of the problems addressed by the present invention. The applicant hereby gives notice that new claims may be formulated to such features during prosecution of this application or of any such further application derived therefrom.

**Claims**

1. A gain control circuit for a CDMA receiver including a controllable input amplifier, comprising:
   a first input port for receiving a wideband power level signal from a wideband stage of said receiver; a second input port for receiving a narrowband power level signal from a narrowband stage of said receiver; and a combiner for combining said wideband and narrowband power level signals to generate a gain control signal for supply to said input amplifier.

2. A circuit as claimed in claim 1. in which said combiner is arranged to form a linear combination of said wideband power level signal and said narrowband power level signal as said gain control signal.

3. A circuit according to claim 2, in which said combiner is arranged to multiply said narrowband level signal and said wideband level signal by respective weighting coefficients and to add the respective products to form said linear combination.

4. A circuit according to any preceding claim, in which said combiner is less responsive to said narrowband level signal prior to acquisition of a CDMA signal by said receiver.

5. A CDMA receiver comprising a controllable amplifier, a wideband stage, a narrowband stage, and a gain control circuit according to any preceding claim.

6. A receiver according to claim 5 comprising a plurality of parallel decoding branches arranged to decode said CDMA signal with different delays.

7. A mobile user terminal comprising a receiver according to claim 5 or claim 6.

8. A method of gain control of a controllable amplifier in a CDMA receiver comprising forming a combination of a wideband power level signal and a narrowband power level signal and using said combination to control said amplifier.

9. A method of CDMA communications comprising controlling receiver gain according to the method of claim 8.

# Fig.1.

MOBILE — 10a

BS — 20

MOBILE — 10b

MSC — 30

PLMN, PSTN — 40

# Fig.2.

# Fig.3.

# Fig.4.

# Fig.5.

**European Patent Office**

## EUROPEAN SEARCH REPORT

Application Number

EP 98 30 4791

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 673 125 A (NIPPON TELEGRAPH & TELEPHONE) 20 September 1995 * column 7, line 48 - column 9, line 43; figure 1 * | 1 | H03G3/30 H04B1/707 H04B7/08 |
| A | FR 2 696 298 A (COMMISSARIAT ENERGIE ATOMIQUE) 1 April 1994 * page 7, line 15 - line 34; figure 1 * | 1 | |
| D,A | US 4 993 044 A (AKAZAWA SHIGEO) 12 February 1991 * abstract * | 1 | |
| D,A | US 5 132 985 A (HASHIMOTO TAKESHI ET AL) 21 July 1992 * abstract * | 1 | |
| A | US 5 617 060 A (WILSON NATHANIEL B ET AL) 1 April 1997 * abstract; figure 3 * | 1 | |
| | | | TECHNICAL FIELDS SEARCHED (Int.Cl.6) |
| | | | H04B H03G |

The present search report has been drawn up for all claims

| Place of search | Date of completion of the search | Examiner |
|---|---|---|
| THE HAGUE | 16 October 1998 | Blaas, D-L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document